# EUROPEAN PATENT SPECIFICATION

(11) **EP 3 088 984 B1**
(45) Date of publication and mention of the grant of the patent: **20.12.2017**
(21) Application number: 15165693.1
(22) Date of filing: 29.04.2015
(51) Int. Cl.: G05D 22/02, H05K 5/02, H05K 7/20

(54) **ELECTRICAL ASSEMBLY COMPRISING MEANS FOR HUMIDITY PREVENTION**
ELEKTRISCHE BAUGRUPPE MIT MITTELN ZUR FEUCHTIGKEITSPRÄVENTION
ENSEMBLE ÉLECTRIQUE COMPRENANT DES MOYENS DE PRÉVENTION DE L'HUMIDITÉ

(43) Date of publication of application: 02.11.2016
(73) Proprietor: ABB Schweiz AG, 5400 Baden (CH)
(72) Inventor: Kokkonen, Jesse, 00380 Helsinki (FI); Myller, Mikko, 00380 Helsinki (FI); Jussila, Matti T., 00380 Helsinki (FI)
(74) Representative: Kolster Oy Ab

(56) References cited:
- CN-U- 203 133 642
- US-A- 5 934 368

## Description

### FIELD OF THE INVENTION

The present invention relates to an electrical assembly comprising means for humidity prevention.

An electrical assembly for outdoor use is often equipped with humidity prevention means or dehumidification means. A known electrical assembly comprises heating resistor means located inside a housing of the electrical assembly, the heating resistor means being adapted for heating inside the housing in order to reduce relative humidity inside the housing. The heating resistor means is controlled by a humidistat or a thermostat, or by a combination thereof. One of the disadvantages associated with the above electrical assembly is that the heating resistor means is expensive. Further, the heating resistor means requires plenty of space inside the housing.

### BRIEF DESCRIPTION OF THE INVENTION

An object of the present invention is to provide an electrical assembly so as to alleviate the above disadvantages. The objects of the invention are achieved by an electrical assembly which is characterized by what is stated in the independent claim. Preferred embodiments of the invention are disclosed in the dependent claims.

The invention is based on the realization that existing electrical components inside a housing of an electrical assembly can be utilized for heating inside the housing, wherein the heating effect is based on waste heat of the existing electrical components. Humidity prevention is carried out or at least assisted by turning on or starting at least one electrical device that otherwise is not required to be on.

An advantage of the electrical assembly of the invention is that a conventional heating resistor can be designed smaller or a conventional heating resistor can be omitted completely since humidity can be prevented by electrical devices that originally were designed for purposes other than heating. Such a smaller heating resistor is cheaper and requires less space than a conventional heating resistor designed to prevent humidity by itself.

### BRIEF DESCRIPTION OF THE DRAWINGS

In the following the invention will be described in greater detail by means of preferred embodiments with reference to the attached drawings, in which
Figure 1 shows an electrical assembly according to an embodiment of the invention; and
Figure 2 shows an electrical assembly according to another embodiment of the invention.

### DETAILED DESCRIPTION OF THE INVENTION

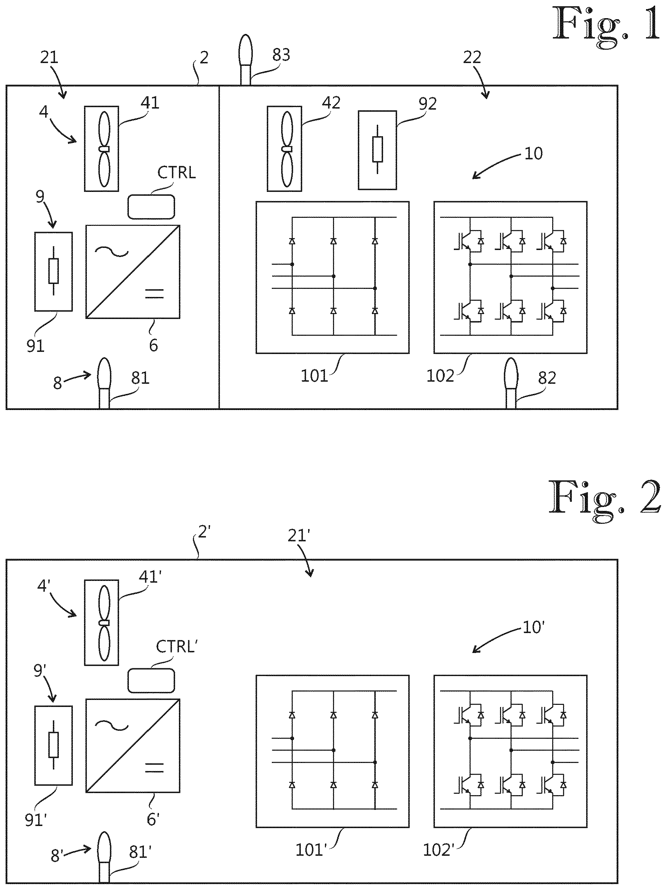

Figure 1 shows an electrical assembly comprising a housing 2, a fan means 4, a power supply 6, a sensor means 8, a control means CTRL, a heating resistor means 9, and a power conversion means 10. The housing 2 is divided into a first chamber 21 and a second chamber 22 separated from the first chamber 21.

The power supply 6 is adapted to supply power to a load means. The power supply 6 is located inside the housing 2, in the first chamber 21. The load means comprises the fan means 4 adapted to generate an air flow inside the housing 2. The power conversion means 10 comprises a frequency converter having a rectifier unit 101 and an inverter unit 102. In an alternative embodiment, a power conversion means comprises a DC-to-DC converter, an inverter, or some other assembly adapted to convert electric energy from one form to another.

The sensor means 8 comprises a power supply space sensor 81, a second chamber sensor 82, and an ambient sensor 83, each one of which is adapted to send information to the control means CTRL. The power supply space sensor 81 is adapted to detect humidity and temperature inside the first chamber 21. The second chamber sensor 82 is adapted to detect humidity and temperature inside the second chamber 22. The ambient sensor 83 is adapted to detect ambient temperature present outside the housing 2. In an alternative embodiment, a sensor means comprises only one sensor, namely a power supply space sensor adapted to detect conditions inside a space in which the power supply is located, the conditions comprising humidity and/or temperature.

In an embodiment, the sensor means is adapted to detect relative humidity. In alternative embodiments, the sensor means is adapted to detect absolute humidity or specific humidity, for example. Herein humidity prevention and dehumidification mean actions that reduce relative humidity inside the housing. The purpose of humidity prevention or dehumidification is to prevent water from condensing into a liquid inside the housing. Therefore, humidity prevention or dehumidification does not necessarily remove water from the housing.

The control means CTRL is adapted to receive information from the sensor means 8, and to control the power supply 6, the fan means 4, the heating resistor means 9 and the power conversion means 10. The control means CTRL is adapted to perform at least one humidity prevention action in a predetermined humidity situation detected based on the information received from the sensor means 8.

The at least one humidity prevention action comprises turning on the power supply 6 when a predetermined humidity situation occurs while the power supply 6 is in OFF state. Turning on the power supply 6 generates waste heat that is utilized for dehumidification. In a situation where a predetermined humidity situation occurs while the power supply 6 is already in ON state, the power supply 6 is naturally kept in the on state and appropriate additional measures are taken.

The control means CTRL is adapted to turn off the power supply 6 in a predetermined energy saving situation where the load means does not require electric power and no predetermined humidity situation is present. This function helps saving energy in conditions where the load means does not continuously require electric power and humidity is a potential problem only occasionally.

In an alternative embodiment, the control means is adapted to control exclusively a power supply adapted to supply power to the fan means. In a simple embodiment, the fan means comprises only a power supply space fan connected to the power supply without a separate control. In this embodiment, the power supply space fan generates an air flow when the power supply is on.

The fan means 4 comprises a power supply space fan 41 and a second chamber fan 42. The power supply space fan 41 is located in the first chamber 21 and is adapted to generate an air flow inside the first chamber 21. The second chamber fan 42 is located in the second chamber 22 and is adapted to generate an air flow inside the second chamber 22.

The heating resistor means 9 comprises a power supply space heating resistor 91 and a second chamber heating resistor 92. The power supply space heating resistor 91 is located inside the first chamber 21 and adapted for heating inside the first chamber 21. The second chamber heating resistor 92 is located inside the second chamber 22 and adapted for heating inside the second chamber 22. In an alternative embodiment, the heating resistor means comprises only one heating resistor located inside the housing and adapted for heating inside the housing. In another alternative embodiment, the heating resistor means comprises a controllable heating resistor means wherein the control means is adapted to control power of the controllable heating resistor means.

The power of at least one humidity prevention action can be controlled in several ways. The controlling of the power of the load means affects both waste heat of the power supply and waste heat of the load means. In general a dehumidification process can be carried out or assisted by turning on any electrical device that otherwise is not required to be on. Therefore, the power of at least one humidity prevention action can be controlled by choosing which excess devices are turned on and by controlling the power of the excess devices if possible. The excess devices provide additional heating capacity practically without any additional hardware, simply by controlling the excess devices in a novel way. In some embodiments, a conventional heating resistor means can be omitted completely and at least one humidity prevention action can be carried out by electrical devices that originally were designed for purposes other than heating.

In alternative embodiments, the at least one humidity prevention action comprises one or more of the following: starting the fan means, turning on the power conversion means, turning on the heating resistor means at least partially. In an embodiment, the at least one humidity prevention action comprises controlling the power of the fan means as a response to the information received from the sensor means.

The control means CTRL is adapted to store information about operating temperature ranges of the power supply 6, the load means and the power conversion means 10, and to utilize said information when selecting a humidity prevention action. The control means CTRL is adapted to realize at least one humidity prevention action with electrical devices whose operating temperature ranges allow them to be turned on at the time in question. For example, if a predetermined humidity situation is detected at a time when temperature inside the housing is -38°C, and the lowest operating temperatures of a power supply, a power supply space fan, and a power conversion means are -40°C, -35°C, and -20°C, respectively, the control means is adapted to start at least one humidity prevention action by turning on the power supply and optionally the heating resistor means at least partially. When the temperature inside the housing reaches -35°C, the control means turns on the power supply space fan, and when the temperature inside the housing reaches -20°C, the control means turns on the power conversion means, provided that a predetermined humidity situation is still present.

The control means CTRL is adapted to store information about location of different components of the electrical assembly. Consequently, the control means CTRL knows that the power supply 6, the power supply space fan 41 and the power supply space heating resistor 91 are available for performing at least one humidity prevention action in the first chamber 21, and the second chamber fan 42, the second chamber heating resistor 92, the rectifier unit 101 and the inverter unit 102 are available for performing at least one humidity prevention action in the second chamber 22.

In an embodiment, the control means is adapted to eliminate a predetermined humidity situation as fast as possible. In such an embodiment, the control means is adapted to keep all available electrical devices at maximum power until the predetermined humidity situation is over.

A predetermined humidity situation is present when humidity inside the first chamber exceeds a predetermined humidity limit value. As a response to a detected humidity situation, the control means turns on the power supply and starts the power supply space fan. If the power supply already is in on state, the control means only starts the power supply space fan. It is also possible to control the power of the fan means as a response to the information received from the sensor means. Increasing the power of the power supply space fan reduces humidity in the first chamber firstly through increasing waste heat of the power supply space fan, and secondly through increasing waste heat of the power supply. In another predetermined humidity situation where humidity inside the second chamber exceeds a predetermined humidity limit value, the control means turns on the power supply and starts the second chamber fan.

The fan means 4 not only provides waste heat dehumidifying air inside the housing but also mixes air inside the housing, thereby evening out humidity conditions in different portions of the housing. The power supply space fan 41 is adapted for dehumidifying the first chamber 21, and the second chamber fan 42 is adapted for dehumidifying the second chamber 22.

Another predetermined humidity situation is present when the temperature inside the housing 2 is lower than the ambient temperature present outside the housing 2. This type of indirect detection of a potential humidity problem can be used as an alternative to direct humidity detection or as a complementary method.

In alternative embodiments, the sensor means and the control means are at least partially integrated, wherein the electrical assembly comprises condition-sensitive switch means adapted to control the power supply, the condition-sensitive switch means comprising a humidistat or a thermostat, or a combination thereof. Alternatively, it is possible to provide a control means, a humidity sensor and a temperature sensor as separate components, or it is possible to integrate a humidity sensor and a temperature sensor and provide a control means as a separate component.

Figure 2 shows an electrical assembly comprising a housing 2', a fan means 4', a power supply 6', a sensor means 8', a control means CTRL', a heating resistor means 9', and a power conversion means 10'. The electrical assembly of Figure 2 is a modification of the electrical assembly shown in Figure 1. Differences between the electrical assemblies of Figures 1 and 2 are discussed below.

The housing 2' only has a first chamber 21'. The power conversion means 10' is located in the first chamber 21'. The fan means 4' comprises only one fan, a power supply space fan 41'. The sensor means 8' comprises only one sensor, a power supply space sensor 81' adapted to detect humidity inside the first chamber 21'. The heating resistor means 9' comprises only one heating resistor, a power supply space heating resistor 91'.

The electrical assembly of Figure 2 is adapted to function in a way similar to that employed in the electrical assembly of Figure 1. Due to the different structure, some functions are realized differently. For example, all the electrical devices are available for performing at least one humidity prevention action in the first chamber 21' since all the electrical devices are located in the first chamber 21'. A predetermined humidity situation is present only when humidity inside the first chamber 21' exceeds a predetermined humidity limit value.

It will be obvious to a person skilled in the art that the inventive concept can be implemented in various ways. The invention and its embodiments are not limited to the examples described above but may vary within the scope of the claims.

## Claims

1. An electrical assembly comprising:
a housing (2);
a power supply (6) adapted to supply power to a load means, the power supply (6) being located inside the housing (2);
a sensor means (8) adapted to detect conditions inside the housing (2), the conditions comprising humidity and/or temperature; and
a control means (CTRL) adapted to control the power supply (6), the control means (CTRL) being adapted to receive information from the sensor means (8), and to perform at least one humidity prevention action in a predetermined humidity situation detected based on the information received from the sensor means (8),
**characterized in that** the at least one humidity prevention action comprises turning on the power supply (6) when a predetermined humidity situation occurs while the power supply (6) is in off state.

2. An electrical assembly according to claim 1, **characterized in that** the control means (CTRL) is adapted to turn off the power supply (6) in a predetermined energy saving situation where the load means does not require electric power and no predetermined humidity situation is present.

3. An electrical assembly according to claim 1 or 2, **characterized in that** the load means comprises a fan means (4) adapted to generate an air flow inside the housing (2), the control means (CTRL) is adapted to control the fan means (4), and the at least one humidity prevention action comprises starting the fan means (4).

4. An electrical assembly according to claim 3, **characterized in that** the at least one humidity prevention action comprises controlling the power of the fan means (4) as a response to the information received from the sensor means (8).

5. An electrical assembly according to any one of claims 1 to 4, **characterized in that** the sensor means (8) comprises a power supply space sensor (81) adapted to detect humidity inside a space in which the power supply (6) is located, and the predetermined humidity situation comprises a situation where humidity inside the space in which the power supply (6) is located exceeds a predetermined humidity limit value.

6. An electrical assembly according to any one of claims 1 to 5, **characterized in that** the sensor means (8) comprises a power supply space sensor (81) adapted to detect temperature inside a space in which the power supply (6) is located, and an ambient sensor (83) adapted to detect ambient temperature present outside the housing (2), and the predetermined humidity situation comprises a situation where the temperature inside the space in which the power supply (6) is located is lower than the ambient temperature.

7. An electrical assembly according to any one of claims 1 to 6, **characterized in that** the electrical assembly comprises a heating resistor means (9) located inside the housing (2) and adapted for heating inside the housing (2), the control means (CTRL) is adapted to control the heating resistor means (9), and the at least one humidity prevention action comprises turning on the heating resistor means (9) at least partially.

8. An electrical assembly according to any one of claims 1 to 7, **characterized in that** the electrical assembly comprises a power conversion means (10) located inside the housing (2), the power conversion means (10) being adapted to convert electric energy from one form to another, and the control means (CTRL) is adapted to control the power conversion means (10).

9. An electrical assembly according to claim 8, **characterized in that** the at least one humidity prevention action comprises turning on the power conversion means (10) when a predetermined humidity situation occurs while the power conversion means (10) is in off state and is not required to convert electric energy.

10. An electrical assembly according to claim 8 or 9, **characterized in that** the electrical assembly comprises a first chamber (21) and a second chamber (22) separated from the first chamber (21), the first chamber (21) and the second chamber (22) being located inside the housing (2), wherein the power supply (6) is located inside the first chamber (21), and the power conversion means (10) is located inside the second chamber (22).

11. An electrical assembly according to claim 10, **characterized in that** the fan means (4) comprises a second chamber fan (42) adapted to generate an air flow inside the second chamber (22), the sensor means (8) comprises a second chamber sensor (82) adapted to detect conditions inside the second chamber (22), the conditions comprising humidity and/or temperature, wherein a predetermined humidity situation comprises a situation where humidity inside the second chamber (22) exceeds a predetermined humidity limit value or where temperature inside the second chamber (22) is lower than the ambient temperature, and the at least one humidity prevention action comprises starting the second chamber fan (42).

12. An electrical assembly according to any one of claims 1 to 11, **characterized in that** the sensor means and the control means are at least partially integrated, wherein the electrical assembly comprises condition-sensitive switch means adapted to control the power supply, the condition-sensitive switch means comprising a humidistat or a thermostat, or a combination thereof.

13. An electrical assembly according to any one of claims 1 to 5, **characterized in that** the sensor means (8) comprises a power supply space sensor (81) adapted to detect temperature inside a space in which the power supply (6) is located, and the control means (CTRL) is adapted to store information about an operating temperature range of the power supply (6) and to utilize said information when selecting at least one humidity prevention action.

## Patentansprüche

1. Elektrische Baugruppe, umfassend:
ein Gehäuse (2);
eine Stromversorgung (6), die ausgelegt ist, eine Last mit Strom zu versorgen, wobei die Stromversorgung (6) innerhalb des Gehäuses (2) angeordnet ist;
ein Sensormittel (8), das ausgelegt ist, Bedingungen innerhalb des Gehäuses (2) zu erfassen, wobei die Bedingungen Feuchtigkeit und / oder Temperatur umfassen; und
ein Steuermittel (CTRL), das ausgelegt ist, die Stromversorgung (6) zu steuern, wobei das Steuermittel (CTRL) ausgelegt ist, Information von dem Sensormittel (8) zu empfangen und mindestens eine Aktion zur Feuchtigkeitsverhinderung in einer vorgegebenen Feuchtigkeitssituation auf der Basis von der von dem Sensormittel (8) empfangenen Information durchzuführen,
**dadurch gekennzeichnet, dass** die mindestens eine Aktion zur Feuchtigkeitsverhinderung das Einschalten der Stromversorgung (6) umfasst, wenn eine vorgegebene Feuchtigkeitssituation auftritt, während die Stromversorgung (6) im Aus-Zustand ist.

2. Elektrische Baugruppe nach Anspruch 1,
**dadurch gekennzeichnet, dass** das Steuermittel (CTRL) ausgelegt ist, die Stromversorgung (6) in einer vorgegebenen Energiesparsituation auszuschalten, in der das Lastmittel keine elektrische Energie benötigt und keine vorgegebene Feuchtigkeitssituation vorliegt.

3. Elektrische Baugruppe nach Anspruch 1 oder 2,
**dadurch gekennzeichnet, dass** das Lastmittel ein Lüftermittel (4) umfasst, das ausgelegt ist, einen Luftstrom innerhalb des Gehäuses (2) zu erzeugen, wobei das Steuermittel (CTRL) ausgelegt ist, das Lüftermittel (4) zu steuern, und wobei die mindestens eine Aktion zur Feuchtigkeitsverhinderung das Starten des Lüftermittels (4) umfasst.

4. Elektrische Baugruppe nach Anspruch 3,
**dadurch gekennzeichnet, dass** die mindestens eine Aktion zur Feuchtigkeitsverhinderung das Steuern der Leistung des Lüftermittels (4) als Reaktion auf die von der Sensormittel (8) empfangene Information umfasst.

5. Elektrische Baugruppe nach einem der Ansprüche 1 bis 4,
**dadurch gekennzeichnet, dass** das Sensormittel (8) einen Stromversorgungsraumsensor (81) umfasst, der ausgelegt ist, Feuchtigkeit im Inneren des Raumes zu erfassen, in dem sich die Stromversorgung (6) befindet, und wobei die vorgegebene Feuchtigkeitssituation eine Situation umfasst, in der die Feuchtigkeit innerhalb des Raumes, in dem sich die Stromversorgung (6) befindet, einen vorgegebenen Feuchtigkeitsgrenzwert überschreitet

6. Elektrische Baugruppe nach einem der Ansprüche 1 bis 5,
**dadurch gekennzeichnet, dass** das Sensormittel (8) einen Stromversorgungsraumsensor (81), der ausgelegt ist, die Temperatur innerhalb eines Raumes, in dem sich die Stromversorgung (6) befindet, zu erfassen, und einen Umgebungssensor (83) umfasst, der ausgelegt ist, die Umgebungstemperatur zu erfassen, die außerhalb des Gehäuses (2) vorhanden ist, und wobei die vorgegebene Feuchtigkeitssituation eine Situation umfasst, in der die Temperatur innerhalb des Raumes, in dem sich die Stromversorgung (6) befindet, niedriger als die Umgebungstemperatur ist.

7. Elektrische Baugruppe nach einem der Ansprüche 1 bis 6,
**dadurch gekennzeichnet, dass** die elektrische Baugruppe ein Heizwiderstandsmittel (9) umfasst, das sich im Inneren des Gehäuses (2) befindet und ausgelegt ist, im Inneren des Gehäuses (2) zu heizen, wobei das Steuermittel (CTRL) ausgelegt ist, das Heizwiderstandsmittel (9) zu steuern, und wobei die mindestens eine Aktion zur Feuchtigkeitsverhinderung das zumindest teilweise Einschalten des Heizwiderstandsmittels (9) umfasst.

8. Elektrische Baugruppe nach einem der Ansprüche 1 bis 7,
**dadurch gekennzeichnet, dass** die elektrische Baugruppe ein Mittel zur Leistungsumwandlung (10) umfasst, das sich innerhalb des Gehäuses (2) befindet, wobei das Mittel zur Leistungsumwandlung (10) ausgelegt ist, elektrische Energie von einer Form in eine andere umzuwandeln, und wobei das Steuermittel (CTRL) ausgelegt ist, um das Mittel zur Leistungsumwandlung (10) zu steuern.

9. Elektrische Baugruppe nach Anspruch 8,
**dadurch gekennzeichnet, dass** die mindestens eine Aktion zur Feuchtigkeitsverhinderung das Einschalten des Mittels zur Leistungsumwandlung (10) umfasst, wenn eine vorgegebene Feuchtigkeitssituation auftritt, während das Mittel zur Leistungsumwandlung (10) im Aus-Zustand ist und nicht benötigt wird, um elektrische Energie umzuwandeln.

10. Elektrische Baugruppe nach Anspruch 8 oder 9,
**dadurch gekennzeichnet, dass** die elektrische Baugruppe eine erste Kammer (21) und eine zweite Kammer (22) umfasst, die von der ersten Kammer (21) getrennt ist, wobei sich die erste Kammer (21) und die zweite Kammer (22) innerhalb des Gehäuses (2) befinden, wobei sich die Stromversorgung (6) innerhalb der ersten Kammer (21) befindet, und wobei sich das Mittel zur Leistungsumwandlung (10) innerhalb der zweiten Kammer (22) befindet.

11. Elektrische Baugruppe nach Anspruch 10,
**dadurch gekennzeichnet, dass** das Lüftermittel (4) einen zweiten Kammerlüfter (42) umfasst, der ausgelegt ist, einen Luftstrom innerhalb der zweiten Kammer (22) zu erzeugen, wobei das Sensormittel (8) einen zweiten Kammersensor (82) umfasst, der ausgelegt ist, Bedingungen innerhalb der zweiten Kammer (22) zu erfassen, wobei die Bedingungen Feuchtigkeit und / oder Temperatur umfassen, wobei eine vorgegebene Feuchtigkeitssituation eine Situation umfasst, in der die Feuchtigkeit innerhalb der zweiten Kammer (22) einen vorgegebenen Feuchtigkeitsgrenzwert überschreitet, oder in der die Temperatur innerhalb der zweiten Kammer (22) niedriger als die Umgebungstemperatur ist, und wobei die mindestens eine Aktion zur Feuchtigkeitsverhinderung das Starten des zweiten Kammerlüfters (42) umfasst.

12. Elektrische Baugruppe nach einem der Ansprüche 1 bis 11,
**dadurch gekennzeichnet, dass** das Sensormittel und das Steuermittel zumindest teilweise integriert sind, wobei die elektrische Baugruppe ein bedingungsempfindliches Schaltmittel umfasst, das ausgelegt ist, die Stromversorgung zu steuern, wobei das bedingungsempfindliche Schaltmittel ein Hygrostat oder ein Thermostat oder eine Kombination davon umfasst.

13. Elektrische Baugruppe nach einem der Ansprüche 1 bis 5,
**dadurch gekennzeichnet, dass** das Sensormittel (8) einen Stromversorgungsraumsensor (81) umfasst, der ausgelegt ist, eine Temperatur innerhalb des Raumes, in dem sich die Stromversorgung (6) befindet, zu erfassen, und dass das Steuermittel (CTRL) ausgelegt ist, Information über einen Betriebstemperaturbereich der Stromversorgung (6) zu speichern, und diese Information bei der Auswahl mindestens einer Aktion zur Feuchtigkeitsverhinderung zu verwenden.

## Revendications

1. Ensemble électrique comprenant :
un logement (2) ;
une source d'alimentation (6) adaptée pour fournir une alimentation à un moyen de charge, la source d'alimentation (6) étant située à l'intérieur du logement (2) ;
un moyen formant capteur (8) adapté pour détecter des conditions à l'intérieur du logement (2), les conditions comprenant l'humidité et/ou la température ; et
un moyen de commande (CTRL) adapté pour commander la source d'alimentation (6), le moyen de commande (CTRL) étant adapté pour recevoir des informations du moyen formant capteur (8), et pour effectuer au moins une action de prévention contre l'humidité dans une situation d'humidité prédéterminée détectée sur la base des informations reçues du moyen formant capteur (8),
**caractérisé en ce que** l'au moins une action de prévention contre l'humidité comprend l'allumage de la source d'alimentation (6) lorsqu'une situation d'humidité prédéterminée survient alors que la source d'alimentation (6) est dans un état inactif.

2. Ensemble électrique selon la revendication 1, **caractérisé en ce que** le moyen de commande (CTRL) est adapté pour éteindre la source d'alimentation (6) dans une situation d'économie d'énergie prédéterminée où le moyen de charge ne requiert pas d'alimentation électrique et aucune situation d'humidité prédéterminée n'est présente.

3. Ensemble électrique selon la revendication 1 ou 2, **caractérisé en ce que** le moyen de charge comprend un moyen formant ventilateur (4) adapté pour générer un flux d'air à l'intérieur du logement (2), le moyen de commande (CTRL) est adapté pour commander le moyen formant ventilateur (4), et l'au moins une action de prévention contre l'humidité comprend le démarrage du moyen formant ventilateur (4).

4. Ensemble électrique selon la revendication 3, **caractérisé en ce que** l'au moins une action de prévention contre l'humidité comprend la commande de l'alimentation du moyen formant ventilateur (4) en réponse aux informations reçues du moyen formant capteur (8).

5. Ensemble électrique selon l'une quelconque des revendications 1 à 4, **caractérisé en ce que** le moyen formant capteur (8) comprend un capteur d'espace de source d'alimentation (81) adapté pour détecter l'humidité à l'intérieur d'un espace dans lequel est située la source d'alimentation (6), et la situation d'humidité prédéterminée comprend une situation où l'humidité à l'intérieur de l'espace dans lequel est située la source d'alimentation (6) dépasse une valeur limite d'humidité prédéterminée.

6. Ensemble électrique selon l'une quelconque des revendications 1 à 5, **caractérisé en ce que** le moyen formant capteur (8) comprend un capteur d'espace de source d'alimentation (81) adapté pour détecter la température à l'intérieur d'un espace dans lequel est située la source d'alimentation (6), et un capteur ambiant (83) adapté pour détecter la température ambiante présente à l'extérieur du logement (2), et la situation d'humidité prédéterminée comprend une situation où la température à l'intérieur de l'espace dans lequel est située la source d'alimentation (6) est inférieure à la température ambiante.

7. Ensemble électrique selon l'une quelconque des revendications 1 à 6, **caractérisé en ce que** l'ensemble électrique comprend un moyen formant résistance chauffante (9) situé à l'intérieur du logement (2) et adapté pour chauffer à l'intérieur du logement (2), le moyen de commande (CTRL) est adapté pour commander le moyen formant résistance de chauffage (9), et l'au moins une action de prévention contre l'humidité comprend l'allumage au moins partiel du moyen formant résistance chauffante (9).

8. Ensemble électrique selon l'une quelconque des revendications 1 à 7, **caractérisé en ce que** l'ensemble électrique comprend un moyen de conversion d'alimentation (10) situé à l'intérieur du logement (2), le moyen de conversion d'alimentation (10) étant adapté pour convertir l'énergie électrique d'une forme à une autre, et le moyen de commande (CTRL) est adapté pour commander le moyen de conversion d'alimentation (10).

9. Ensemble électrique selon la revendication 8, **caractérisé en ce que** l'au moins une action de prévention contre l'humidité comprend l'allumage du moyen de conversion d'alimentation (10) lorsqu'une situation d'humidité prédéterminée se produit alors que le moyen de conversion d'alimentation (10) est dans l'état inactif et n'a pas besoin de convertir l'énergie électrique.

10. Ensemble électrique selon la revendication 8 ou 9, **caractérisé en ce que** l'ensemble électrique comprend une première chambre (21) et une seconde chambre (22) séparée de la première chambre (21), la première chambre (21) et la seconde chambre (22) étant situées à l'intérieur du logement (2), dans lequel la source d'alimentation (6) est située à l'intérieur de la première chambre (21), et le moyen de conversion d'alimentation (10) est situé à l'intérieur de la seconde chambre (22).

11. Ensemble électrique selon la revendication 10, **caractérisé en ce que** le moyen formant ventilateur (4) comprend un ventilateur de seconde chambre (42) adapté pour générer un flux d'air à l'intérieur de la seconde chambre (22), le moyen formant capteur (8) comprend un capteur de seconde chambre (82) adapté pour détecter des conditions à l'intérieur de la seconde chambre (22), les conditions comprenant l'humidité et/ou la température, dans lequel une situation d'humidité prédéterminée comprend une situation où l'humidité à l'intérieur de la seconde chambre (22) dépasse une valeur limite d'humidité prédéterminée ou lorsque la température à l'intérieur de la seconde chambre (22) est inférieure à la température ambiante, et l'au moins une action de prévention contre l'humidité comprend le démarrage du second ventilateur de chambre (42).

12. Ensemble électrique selon l'une quelconque des revendications 1 à 11, **caractérisé en ce que** le moyen formant capteur et le moyen de commande sont au moins partiellement intégrés, dans lequel l'ensemble électrique comprend un moyen de commutation sensible aux conditions adapté pour commander la source d'alimentation, le moyen de commutation sensible aux conditions comprenant un humidistat ou un thermostat, ou une combinaison de ceux-ci.

13. Ensemble électrique selon l'une quelconque des revendications 1 à 5, **caractérisé en ce que** le moyen formant capteur (8) comprend un capteur d'espace de source d'alimentation (81) adapté pour détecter la température à l'intérieur d'un espace dans lequel est située la source d'alimentation (6), et le moyen de commande (CTRL) est adapté pour stocker des informations sur une plage de température de fonctionnement de la source d'alimentation (6) et pour utiliser lesdites informations lors de la sélection d'au moins une action de prévention contre l'humidité.
